Europäisches Patentamt

European Patent Office

Office européen des brevets

(19)

(11) Veröffentlichungsnummer: **0 122 907**

**A1**

(12) # EUROPÄISCHE PATENTANMELDUNG

(21) Anmeldenummer: **84890030.4**

(22) Anmeldetag: **20.02.84**

(51) Int. Cl.³: **H 03 K 17/04**
**H 03 K 17/60**

(30) Priorität: **21.02.83 AT 565/83**

(43) Veröffentlichungstag der Anmeldung:
**24.10.84 Patentblatt 84/43**

(84) Benannte Vertragsstaaten:
**BE CH DE FR GB IT LI LU NL SE**

(71) Anmelder: **STEIRISCHE ELEKTRONIK Ges.m.b.H.**
**Penzinger Strasse 76**
**A-1141 Wien(AT)**

(72) Erfinder: **Ebhardt, Horst, Dr.**
**Rainleiten 45**
**A-8045 Graz(AT)**

(72) Erfinder: **Ruff, Reinhard, Dipl.-Ing.**
**Kauperzgasse 18**
**A-8055 Graz(AT)**

(74) Vertreter: **Krause, Peter**
**Penzinger Strasse 76**
**A-1141 Wien(AT)**

(54) **Ansteuerschaltung für Schalttransistor.**

(57) Die Erfindung betrifft eine Schaltung zur Ansteuerung eines Schalttransistors (1), wobei erfindungsgemäß eine Ansteuerschaltung (7), insbesondere in Form eines integrierten Bausteines, über einen Kondensator (3) mit der Basis des Schalttransistors (1) verbunden ist und zwischen dem Basis-une Emitteranschluß des Schalttransistors (1) ein Widerstand (4) geschaltet ist.

Ansteuerungsschaltung für Schalttransistoren sind bekannt. Allen dieser bekannten Schaltungen liegt das Bestreben zugrunde, die im Schalttransistor freiwerdende Verlustleistung möglichst hering zu halten.

Um geringe Einschaltverluste zu erhalten, muß der Transistor (1) möglichst schnell eingeschaltet werden, d.h. die Kollektor-Emitter-Spannung muß rasch auf die Sättingungsspannung, d.h. auf den im stationären durchgesteuerten Zustand auftretenden Spannungsabfall am Transistor absinken.

Ziel der Erfindung ist es nun, eine möglichst einfache Ansteuerschaltung zu finden, die zu geringen Verlusten im Schalttransistor führt.

Die erfindungsgemäße Schaltanordnung der eingangs erwähnten Art, ist dadurch gekennzeichnet, daß durch das Zusammenwirken der Ansteuerschaltung (7), des Koppelnetzwerkes, bestehend aus Widerstand (4) und Kondensator (3), mit dem Schalttransistor (1) erreicht wird, daß beim Einschalten der Basisstrom einen überhöhten Wert hat, wodurch die Einschaltzeit gering ist, daß während des eingeschalteten Zustandes der Schalttransistor (1) gesättigt ist, daß weiters am Ende des Einzustandes der schalt Transistor (1) im quasigesättigten Bereich arbeitet und daß letztlich beim Ausschalten sowohl zuerst ein hoher negativer Basisstrom, der beim Ausschalten aus dem quasigesättigtem Bereich sehr groß sein darf und nicht genau abgestimmt sein muß) fließen kann als auch eine große negative Spannung zur Verfügung gestellt wird.

FIG 1

Die Erfindung betrifft eine Schaltung zur Ansteuerung eines Schalttransistors, gekennzeichnet dadurch, daß eine Ansteuerschaltung, insbesondere in Form eines integrierten Bausteines, beispielsweise eines LM 555 von der Fa. National über einen Kondensator mit der Basis des Schalttransistors verbunden ist und zwischen dem Basis- und Emitteranschluß des Schalttransistors ein Widerstand geschaltet ist, und der Wert des Kondensators und des Widerstandes durch die Formel

$$C_k = t_{ein} \cdot I_{bend} \cdot K_1$$

bzw.

$$R_B = \frac{U- \cdot t_{aus}}{\triangle U_1 \cdot C_k} \cdot K_2$$

Ansteuerschaltungen für Schalttransistoren sind zum Beispiel im "Handbuch Schalttransistoren" von Thomson CSF aber auch in ähnlichen Schriften von Philips, Siemens u.a. angeführt. Allen diesen bekannten Schaltungen liegt das Bestreben zugrunde, die im Schalttransistor freiwerdende Verlustleistung möglichst gering zu halten. Diese Verluste setzen sich aus Einschalt- und Ausschaltverlusten und den Verlusten, die im leitenden Zustand des Schalttransistors auftreten, zusammen. Den großen Anteil haben dabei die Ausschaltverluste, wenn die Schaltung an hohen Spannungen z.B. am Netz betrieben wird.

0122907

Um geringe Einschaltverluste zu erhalten, muß
der Transistor möglichst schnell eingeschaltet
werden, d.h. die Kollektor-Emitter-Spannung
muß rasch auf die Sättigungsspannung, d.h. auf
den im stationären durchgesteuerten Zustand
auftretenden Spannungsabfall am Transistor,
absinken.
Dazu müssen möglichst schnell Ladungsträger
in die Basiszone des Halbleiterkristalls gebracht werden.

Um geringe Ausschaltverluste zu erhalten,
müssen diese Ladungsträger wieder möglichst
schnell aus der Basiszone entfernt werden.
Außerdem müssen die Löcher in der Kollektorzone
rekombinieren.

Dies erfordert eine Zeit, die umso größer ist,
je mehr der Transistor in der Sättigung ist. Es
ist also vorteilhaft, wenn der Transistor zum
Zeitpunkt des Ausschaltens im "quasigesättigten
Bereich", d.h. in einem Bereich geringer Sättigung
ist, da in diesem Fall weniger Ladungsträger in
der Basis- und Kollektorzone sind.

Dies kann zum Beispiel, wie in der technischen
Information Nr. 34 von Thomson CSF "Basisansteuerung von Hochvolttransistoren" S. 18, dargestellt, durch die Verwendung von Antisättigungsdioden oder wie im selben Werk auf S 19 ff beschrieben durch zeitliche Anpassung des Übergangs vom positiven zum negativen Basisstrom geschehen.

Natürlich ist es leichter mit größerem Aufwand eine optimale Ansteuerung des Schalttransistors zu erreichen, als mit geringem Aufwand.

So wird etwa in oben erwähntem "Handbuch Schalttransistoren" von Thomsen auf S. 117 eine sehr einfache Verbindung zwischen Ansteuerschaltung und Schalttransistor gezeigt. Über einen Transistor ist ein Spannungsteiler mit der positiven Versorgungsspannung der Ansteuerschaltung verbunden.

Das andere Ende des Spannungsteilers ist mit Masse, der Abgriff mit der Basis des Schalttransistors verbunden.

Die Verbindung zwischen Ansteuerschaltung und dem Schalttransistor besteht hier also lediglich aus einem Spannungsteiler, gebildet aus zwei Festwiderständen. Als Eigenschaften sind angeführt:

mittelschnelles Einschalten
sehr geringer Aufwand
große Ausschaltzeit.

Bei einer verbesserten einfachen Ausführung liegt der Spannungsteiler an einer negativen Spannung und nicht an der Masse. Dadurch wird die Ausschaltzeit geringer. Durch Steigerung des Aufwandes wie z.B. Eingangstransformatoren, Gegentaktschaltungen etc., Einführung von Antisättigungsdioden werden die Eigenschaften weiter verbessert.

Ziel der Erfindung ist es nun, eine möglichst einfache Ansteuerschaltung zu finden, die zu geringen Verlusten im Schalttransistor führt.

Die erfindungsgemäße Schaltanordnung der eingangs erwähnten Art, ist dadurch gekennzeichnet, daß durch das Zusammenwirken der Ansteuerschaltung, der Koppelnetzwerkes, bestehend aus Widerstand und Kondensator, mit dem Schalttransistor erreicht wird, daß beim Einschalten der Basisstrom einen überhöhten Wert hat, wodurch die Einschaltzeit gering ist, daß während des einge- schalteten Zustandes der Schalttransistor ge- sättigt ist, daß weiters am Ende des Einzustandes der Transistor im quasigesättigten Bereich arbeitet und daß letztlich beim Ausschalten sowohl zuerst ein hoher negativer Basisstrom, der beim Ausschalten aus dem quasigesättigtem Bereich sehr groß sein darf und nicht genau abgestimmt sein muß, fließen kann, als auch eine große negative Spannung zur Verfügung gestellt wird.

Diese Eigenschaften führen sowohl zu geringen Einschaltverlusten, als auch zu geringen Verlusten in der Leitphase und besonders zu geringen Ausschaltverlusten.

Nach der Erfindung ist die Ansteuerschaltung über einen Kondensator mit der Basiselektrode des Schalttransistors verbunden, wobei die Kapazität dieses Kondensators erfindungsgemäß so dimensioniert ist, daß während des Intervalls, in dem der Schalttransistor leitend ist, nachfolgend kurz Leitphase genannt, sein Ladestrom, der annähernd gleich ist dem Basisstrom des Schalttransistors, zu Beginn überhöht ist, wodurch ein schnelles Einschalten des Schalttransistors gewährleistet ist, und nachfolgend stetig abnimmt, bis er am Ende einen so geringen Wert erreicht hat, daß der Schalttransistor in den quasi gesättigten Zustand übergeht und mit geringen Verlusten ausgeschaltet werden kann.

Da beim Ausschalten des Transistors der positive Pol des Kondensators an die Masse gelegt wird, kommt an die Basis eine negative Spannung zu liegen, die gleich ist der Kondensatorspannung zum Zeitpunkt des Ausschaltens. Dadurch werden die Ladungsträger aus der Basis sehr schnell abgeleitet, wodurch der Kondensator geringfügig entladen wird.

Nach der Erfindung ist weiters ein Widerstand parallel zur Basis und Emitterelektrode geschaltet, der erfindungsgemäß so dimensioniert ist, daß der Kondensator während des Intervalls, in dem der Schalttransistor gesperrt ist, nachfolgend kurz Sperrphase genannt, so weit über diesen Widerstand entladen wird, daß er zu Beginn der nächsten Leitphase einen genügend großen Ladestrom aufnimmt und damit einen genügend großen Basisstrom zur Verfügung stellt.

Eine besonders vorteilhafte Ausführungsform der erfindungsmäßigen Schaltungsanordnung ist gekennzeichnet durch die Verwendung einer integrierten Schaltung LM 555 der Fa. National oder eines äquivalenten Typs einer anderen Firma (z.B. NE 555, SE 555 etc.), nachfolgend kurz Timer IC genannt, als Ansteuerschaltung.

Eine andere vorteilhafte Ausführungsform der erfindungsgemäßen Schaltanordnung ist gekennzeichnet durch die Verwendung von Mehrfachanordnungen dieses Timers in einer integrierten Schaltung, beispielsweise eines LM 556, wobei entweder nur ein Timer für die Bedienung des Schalttransistors, der oder die anderen Timer für Zusatzfunktionen verwendet werden, oder mit einer integrierten Schaltung mit mehreren Timern mehrere Schalttransistoren angesteuert werden.

0122907

Dieser Timer besitzt intern eine Gegentaktausgangsschaltung, die Ströme bis 200 mA schalten kann. Die Ausgangstransistoren besitzen eine Strom-Spannungscharakteristik, die ein ideales Zusammenwirken mit der übrigen Schaltung gewährleisten.

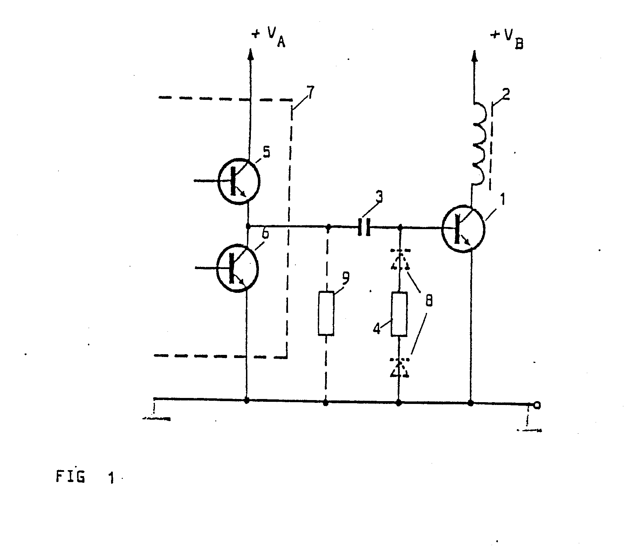

Die Erfindung wird nachstehend anhand von der Fig. 1 dargestellten, besonders vorteilhaften Ausführungsform näher erläutert.

In Fig. 1 ist ein npn Hochspannungsleistungstransistor 1 dargestellt, dessen Kollektor über eine Induktivität 2 mit dem Pluspol $+V_B$ der Speisespannungsquelle verbunden ist. Der Minuspol derselben liegt an Masse. Der Emitteranschluß des Hochspannungsschalttransistors 1 liegt ebenso an Masse. Über einen Kondensator 3 ist die Basis dieses Transistor mit dem Ausgang der Ansteuerschaltung verbunden, und über den Widerstand 4 mit der Masse. Die Gegentaktausgangsschaltung der Ansteuerschaltung ist als Teil der strichliert angedeuteten Ansteuerschaltung 7 dargestellt und besteht aus den Transistoren 5 und 6, wobei der Transsistor 5 mit dem Kollektor am positiven Pol der Speisespannungsquelle der Ansteuerschaltung, die nicht identisch mit der oben genannten Speisespannungsquelle des Schalttransistors sein muß, verbunden ist.

- 9 -

0122907

Der Emitter ist mit dem Kollektor des Transistors 6 verbunden, dessen Emitter an Masse liegt. Die Verbindungsstelle des Emitters von Transistor 5 mit dem Kollektor von Transistor 6 stellt den Ausgang der Treiberschaltung dar, der, wie oben erwähnt, über den Kondensator 3 mit dem Schalttransistor 1 verbunden ist. Die Induktivität 2 kann die Primärinduktivität eines Wandlertrafos sein, der einen Teil eines zu sich bekannten Gleichspannungswandlers bildet, wobei eine oder mehrere Sekundärwicklungen vorhanden sein können und durch Regeleinrichtungen die Ansteuerung so geregelt werden kann, daß eine von einer Änderung der Betriebsspannung oder Änderung der Belastung unabhängige stabilisierte Gleichspannung erzeugt wird.

Es kann auch nur eine Kontrolleinrichtung vorgesehen sein, die bei Unterbrechung oder Kurzschluß des Ausgangsstromkreises die Ansteuerschaltung und damit den Gleichspannungswandler stoppt.

Der Ausgang der Ansteuerschaltung liegt im Ruhezustand auf ca. ∅V. Über den Widerstand 4 und die durchgeschaltete BE-Strecke des masseseitigen Transistors 6, der Ausgangsschaltung der Ansteuerschaltung 7 wurde der Kondensator entladen. Wird der Ausgang der Ansteuerschaltung 7 nun hochgesteuert, so wird der Kondensator 4 über den Transistor 5 und die BE-Strecke des Schalttransistors 1 und über den Basiswiderstand 4 geladen.

Der Transistor 1 bekommt an der Basis zuerst einen sehr hohen und dann immer geringer werdenden Strom zur Verfügung gestellt. Dadurch wird der Schalttransistor 1 sehr schnell durchgesteuert. Mit größer werdender Einschaltdauer wird der Kondensator immer mehr geladen und der Ladestrom, der ja zum überwiegenden Teil durch den Basisstrom des Schalttransistors gebildet wird, wird geringer. Damit sinkt also auch der Basisstrom. Unterschreitet der Basisstrom einen bestimmten Grenzwert, der vom momentanen Kollektorstrom des Schalttransistors abhängt, so geht der Schalttransistor in den sogenannten "quasigesättigten Betrieb" über, d.h. die Kollektor-Emitterspannung des Schalttransistors wird größer, etwa $5 + 20$ V, und die Stromverstärkung des Transistors steigt stark an.

Aus diesem quasigesättigten Betrieb kann der Transistor wesentlich schneller, und damit mit wesentlich geringerer Verlustleistung abgeschaltet werden.

Erfindungsgemäß dient dieses Zusammenwirken zwischen Ansteuerschaltung 7, Kondensator 3 und Schalttransistor 1 zur Erzielung dieses verlustarmen Abschaltvorganges. Der Widerstand 4 reduziert den Basisstrom des Transistors 1. Stört dieser Effekt, so kann eine Diode 8 zwischen Widerstand 4 und Masse oder Basis geschaltet werden, die in der Leitphase des Transistors 1 in Sperrichtung gepolt ist.

Schaltet der Ausgang der Ansteuerschaltung um, d.h. wird die Ausgangsspannung ca. $\emptyset$ V, so liegt an der Basis des Schalttransistors 1 die Spannung des Kondensators 3 negativ an. Durch diese hohe negative Spannung, die allerdings kleiner als die BE-Durchbruchsspannung des Schalttransistors sein muß, werden die Ladungsträger aus der Basis-Zone des Schalttransistors 1 sehr schnell abgesaugt. Damit der Kondensator 3 wieder in der Leitphase geladen und ein Basisstrom zur Verfügung gestellt werden kann, muß er in der Sperrphase entladen werden. Dies geschieht einerseits durch die Ladungsträger, die aus der Basis-Zone abgesaugt werden, andererseits durch den Widerstand 4, der in der Sperrphase als Entladewiderstand wirkt.

Erfindungsgemäß wird durch die Größe des Widerstandes 4 bestimmt, wie stark der Kondensator 3 entladen wird, und damit, wie groß der Basisstrom ist, den der Kondensator 3 in die Leitphase zur Verfügung stellt. Wählt man den Wert des Widerstandes 4 zu klein, so ist Basisstrom am Ende der Leitphase zu groß, der Transistor 1 ist voll durchgesteuert und braucht lange zum Ausschalten.

Wählt man den Wert des Widerstandes 4 zu groß, so ist der Basisstrom am Ende der Leitphase zu klein, d.h. der Schalttransistor 1 wird zu früh und zu weit entsättigt, die Durchlaßverluste werden größer.

Durch die Ladestromstöße des Koppelkondensators 4 wird der Transistor 5 der Ansteuerschaltung stark belastet. Bei großen Stromwerten steigt die Sättigungsspannung am Transistor 5 an. Auch die BE-Spannung am Schalttransistor steigt geringfügig.

Dadurch wird der Kondensatorstrom, der gleich dem Emitterstrom des Transistors 5 ist, begrenzt.

Erfindungsgemäß muß die Kapazität des Kondensators auf die anderen Bauteile folgendermaßen abgestimmt werden.

Die Summe der Änderungen der CE-Sättigungsspannung des Transistors 5 und der BE-Spannung des Transistors 1, während der Leitphase muß gleich sein der Spannungsänderung des Kondensators 3 beim Entladen während der Sperrphase. Wird die Kapazität des Kondensators zu groß gewählt, so wird die Ausgangsschaltung der Ansteurschaltung überlastet. Wird er zu klein gewählt, so wird er zu schnell entladen.

Das führt zu einem stark entsättigten Schalttransistor 1 am Ende der Leitphase.

Erfindungsgemäß läßt sich die Kapazität des Kondensators 3 durch folgende Formel berechnen:

$$C = t_{ein} \cdot I_{Bend} \cdot k_1$$

wobei C      die Kapazität von Kondensator 4 in $\mu$F

$t_{ein}$      die Dauer des Ein-Zustandes in $\mu$ sec

$I_{Bend}$      der Basisstrom, der maxiaml fließen darf, um den Transistor in gerade noch gesättigtem Zustand zu halten in A

$k_1$      eine empirische Konstante 1 und 4 gewählt werden kann.

Der Basiswiderstand muß auf diesen Kondensator abgestimmt werden.

Erfindungsgemäß läßt sich der Widerstand durch folgende Formel berechnen:

$$R_B = \frac{U_-}{\Delta U_1} \cdot \frac{t_{aus}}{C_K} \cdot k_2$$

Wobei $U_-$ der Spitzenwert der negativen Vorspannung im Auszustand

$t_{aus}$      die Aus-Zeit

$k_2$      eine Konstante 1/1,2

$C_k$      die Kapazität des Koppelkondensators

$\Delta U_1$      die Summe der Spannungsänderung der BE-Spannung des Schalttransistors und der CE-Spannung des oberen Transistors 5 der Ansteuerschaltung.

- 14 -

0122907

Erfindungsgemäß gelten diese Formeln sowohl
für die Verwendung eines Einzeltransistors,
als auch eines Darlingtontransistors als
Schaltransistor.

Weiters wird darauf hingewiesen, daß die Verwendung des LM 555 eine vorteilhafte Variante
einer Ansteuerschaltung darstellt. Genausogut können andere Ansteuerschaltungen, sowohl
in integrierter als auch in diskret aufgebauter
Bauweise mit Gegentaktausgangsstufen verwendet
werden. Es ist aber auch eine Ausgangsstufe mit
einem Transistor, wie die oben erwähnte aus
dem "Handbuch Schalttransistoren" von Thomson
zitierte, möglich.

Der Ausgang der Ansteuerschaltung muß aber in
diesem Fall durch einen niederohmigen Widerstand 9 gegen Masse abgeschlossen sein.

- 15 -

0122907

<u>Patentansprüche</u>

1. Schaltungsanordnung bestehend aus einer Ansteuerschaltung 7, einem Koppelnetzwerk und einem Leistungstransistor 1, gekennzeichnet dadurch, daß der Ausgang der Ansteuerschaltung über einen Kondensator 3 mit der Basis des Schalttransistors 1 verbunden ist und ein Widerstand 4 von der Basiselektrode zum Emitter dieses Schalttransistors 1 geschaltet ist.

2. Schaltungsanordnung nach 1 gekennzeichnet dadurch, daß die Kapazität des Kondensators 3 so gewählt wird, daß am Ende der Leitphase des Schalttransistors 1 der Ladestrom durch den Kondensator 3 so groß ist, daß der Schalttransistor 1 im quasigesättigten Betrieb ist.

3. Schaltungsanordnung nach 1 und 2 gekennzeichnet dadurch, daß der Ohmwert des Widerstandes 4, der zwischen Basis und Emitter des Schalttransistors liegt, so bemessen ist, daß der Ladestrom des Kondensators 3, der Ausgang der Ansteuerschaltung 7 mit der Basis des Schalttransistors 1 verbindet, zu Beginn der Leitphase des Schalttransistors 1 so groß ist, daß dieser sehr schnell eingeschaltet wird.

4. Schaltung nach 1 - 3, dadurch gekennzeichnet, daß die Werte des obengenannten Widerstandes 4 bzw. des Koppelkondensators 3 so gewählt sind, daß die Kapazität des Koppelkondensators 3 gleich

$$C_k = t_{ein} \cdot I_{bend} \cdot K_1$$

wobei

| | |
|---|---|
| $t_{ein}$ | Dauer der Leitphase |
| $I_{Bend}$ | Basisstrom des Schalttransistors für quasigesättigten Betrieb am Ende der Leitphase |
| $K_1$ | eine Konstante, die zwischen 1 und 4 betragen kann ist, und beispielsweise |

$C_k$ in $\mu$F, $t_{ein}$ in $\mu$sec $I_{Bend}$ in A eingesetzt werden.

und, daß der Wert des Widerstandes 4 gleich

$$R = \frac{U -}{\Delta U_1} \cdot \frac{t_{aus}}{C_k} \cdot K_2 \text{ ist}$$

wobei

| | |
|---|---|
| U- | der Spitzenwert der negativen Vorspannung in der Sperrphase |
| $t_{aus}$ | die Dauer der Sperrphase |
| $C_k$ | die Kapazität des Koppelkondensators |
| $\Delta U_1$ | die Änderung der Kollektor-Emitter-Spannung des treibenden Transistors der Ansteuerschaltung vom Beginn bis zum Ende der Leitphase des Schalttransistors ist |
| $K_2$ | eine Konstante im Bereich von 1 bis 1,2. |

0122907

5. Schaltungsanordnung nach 1 - 3 dadurch gekennzeichnet, daß in Serie zum Widerstand 4
mindestens eine Diode 8 so geschaltet ist,
daß deren Kathode in Richtung zur Basis
des Schalttransistors 1 zeigt, wobei diese
Diode 8 sowohl zwischen Widerstand 4 und
Basis des Schalttransistors als auch zwischen Widerstand 4 und Masse geschaltet
sein kann.

6. Schaltungsanordnung nach 1 -3, dadurch gekennzeichnet, daß der Ausgang der Ansteuerschaltung 7 über einen Widerstand 9 mit der
Masse verbunden ist.

7. Schaltungsanordnung nach 1 - 3, dadurch gekennzeichnet, daß der Koppelkondensator ein
Elektrolytkondensator ist.

8. Schaltungsanordnung nach 1 - 3, dadurch gekennzeichnet, daß der Schalttransistor ein
Hochspannungs-Leistungstransistor in einem
Schaltnetzteil, insbesondere zum Betrieb von
Leuchtstofflampen, Niedervoltlampen oder zur
Ladung von Batterien ist.

9. Schaltungsanordnung nach 1 - 3, dadurch gekennzeichnet, daß die Ansteuerschaltung
eine Gegentaktausgangsschaltung enthält.

10. Schaltungsanordnung nach 1 - 3, dadurch gekennzeichnet, daß die Ansteuerschaltung eine integrierte Schaltung, insbesondere ein LM 555 oder ein äquivalenter Bauteil ist.

FIG 1

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | US-A-4 156 273 (T. SATO) * Figur 3, Positionen 6, DF, 2; Figuren 8, 9; Spalte 11, Zeile 43 - Spalte 12, Zeile 26 * | 1,8 | H 03 K 17/04 H 03 K 17/60 |
| | --- | | |
| A | ELEKTROTECHNIK, Band 60, Nr. 3, 10. Februar 1978 K. RISCHMÜLLER "Alternativ zum Transformator", Seiten 12-14 * Bild 3; Seite 13, Zeilen 16-40 * | | |
| | --- | | |
| A | EDN, Band 25, Nr. 19, 20. Oktober 1980, Boston M.W. SMITH "Careful base-drive design optimizes transistor switching", Seiten 105-109 | | |
| | --- | | RECHERCHIERTE SACHGEBIETE (Int. Cl. ³) |
| A | ELEKTRONIK, Nr. 11, 1977 K. RISCHMÜLLER "Basisansteuerung von Hochvolttransistoren", Seiten 55-58 | | H 02 M 1/08 H 02 M 3/335 H 02 M 7/537 |
| | --- | | H 03 K 17/04 |
| A | O. MACEK "Schaltnetzteile, Motorsteuerungen und ihre speziellen Bauteile" 1982, HÜTHIG VERLAG, Heidelberg Seiten 167-175 | | H 03 K 17/60 H 03 K 17/64 H 05 B 41/26 H 05 B 41/28 H 05 B 41/29 |
| | --- | | |
| X | US-A-3 609 405 (J.M. SURPRISE et al.) * Figur 1; Zusammenfassung * | 1,9 | |
| | ---     -/- | | |

Der vorliegende Recherchenbericht wurde für alle Patentansprüche erstellt.

| Recherchenort | Abschlußdatum der Recherche | Prüfer |
|---|---|---|
| BERLIN | 17-04-1984 | ARENDT M |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82

Europäisches
Patentamt

**EUROPÄISCHER RECHERCHENBERICHT**

**0122907**
Nummer der Anmeldung

EP 84 89 0030

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| P,X | Patent Abstracts of Japan Band 7, Nr. 49, 25. Februar 1983 & JP-A-57-199328 (Kat. X, veröffentlicht am 7.12.1982) * Gesamtes Dokument * | 1,8 | |
| A | Patent Abstracts of Japan Band 2, Nr. 82, 30. Juni 1978 Seite 3402E78 & JP-A-53-45959 * Gesamtes Dokument * | 1 | |
| A | DE-B-2 644 507 (SIEMENS AG) * Patentansprüche 1-4; Figuren 2, 3; Spalte 3, Zeile 58 - Spalte 4, Zeile 43 * | 1 | |
| A | FR-A-2 500 251 (SAFT) * Figur, Positionen 2, T1, T2, 9, 10, 11, T3; Seite 2, Zeilen 17-34; Seite 3, Zeile 28 - Seite 4, Zeile 3 * | 1,8-10 | RECHERCHIERTE SACHGEBIETE (Int. Cl. ³) |
| A | US-A-3 244 910 (M.S. LEIFER) * Figur * | 1 | |
| A | TOUTE L'ELECTRONIQUE, Nr. 431, April 1978 "Technologies et applications des transistors de puissance", Seiten 27-36 * Figur 16 * | 1 | |

--- -/-

Der vorliegende Recherchenbericht wurde für alle Patentansprüche erstellt.

| Recherchenort BERLIN | Abschlußdatum der Recherche 17-04-1984 | Prüfer ARENDT M |
|---|---|---|

## EINSCHLÄGIGE DOKUMENTE

Seite 3

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | A. KORONCAI et al. "Der Transistorschalter in der digitalen Technik" 1965, PHILIPS TECHNISCHE BIBLIOTHEK, Eindhoven Kapitel 2, Seiten 31-43 * Abschnitt 2,5 * <br><br>--- | | |
| A | ELEKTRONIK, Nr. 9, 1978, Arbeitsblatt Nr. 112 "Das Schaltverhalten von Transistoren", Seiten 113-116 * Abschnitte 4, 7 * <br><br>----- | | |

RECHERCHIERTE
SACHGEBIETE (Int. Cl. 3)

Der vorliegende Recherchenbericht wurde für alle Patentansprüche erstellt.

| Recherchenort BERLIN | Abschlußdatum der Recherche 17-04-1984 | Prüfer ARENDT M |
|---|---|---|